Europäisches Patentamt

European Patent Office

Office européen des brevets

(19)

(11) Numéro de publication: **0 238 370**
**B1**

(12) **FASCICULE DE BREVET EUROPEEN**

(45) Date de publication du fascicule du brevet:
16.05.90

(51) Int. Cl.⁵: **G11C 19/08**

(21) Numéro de dépôt: **87400241.3**

(22) Date de dépôt: **03.02.87**

(54) **Mémoire à bulles magnétiques en technologie hybride.**

(30) Priorité: **05.02.86 FR 8601574**

(43) Date de publication de la demande:
**23.09.87 Bulletin 87/39**

(45) Mention de la délivrance du brevet:
**16.05.90 Bulletin 90/20**

(84) Etats contractants désignés:
**DE GB NL**

(56) Documents cités:
**EP-A- 0 082 526**

(73) Titulaire: **COMMISSARIAT A L'ENERGIE ATOMIQUE,
31/33, rue de la Fédération, F-75015 Paris(FR)**

(72) Inventeur: **Fedeli, Jean-Marc, 3 rue Bach Le Fontanil,
F-38120 Saint Egreve(FR)**
Inventeur: **Louis, Christine, 5, rue du Drac, F-38120 Saint
Egreve(FR)**
Inventeur: **Magnin, Joel, 3, rue Doyen Gosse,
F-38400 Saint Martin d'Heres(FR)**
Inventeur: **Vabre, Maryse, 5, rue Chenevière,
F-38240 Meylan(FR)**

(74) Mandataire: **Mongrédien, André et al, c/o
BREVATOME 25, rue de Ponthieu, F-75008 Paris(FR)**

ACTORUM AG

## Description

La présente invention a pour objet une mémoire à bulles magnétiques en technologie hybride, et concerne plus particulièrement la jonction permettant à une bulle magnétique de se propager d'une zone à motifs déposés vers une zone implantée.

Dans la suite du texte, une telle jonction sera notée en abrégé jonction PI ou JPI, pour jonction permalloy-implantée.

Dans une mémoire à bulles magnétiques, les bulles magnétiques sont contenues dans une couche magnétique monocristalline, telle qu'un film de grenat magnétique, supportée par un grenat monocristallin amagnétique. Ces bulles se présentent sous la forme de domaines magnétiques isolés, généralement cylindriques, présentant une aimantation inverse de celle du reste de la couche magnétique monocristalline. Ces bulles magnétiques sont stables par application d'un champ magnétique continu $H_{pol}$ perpendiculaire au plan de la couche magnétique. Dans la pratique, ce champ magnétique est créé par un aimant permanent assurant ainsi la non volatilité des informations contenues dans la mémoire à bulles.

Le déplacement des bulles est réalisé en appliquant un champ continu tournant $H_T$ suivant une direction parallèle à la surface de la couche magnétique. Le déplacement des bulles se fait autour de motifs dits de propagation.

Ces motifs présentant la forme de disques, de losanges, de triangles, de T etc... peuvent être réalisés en un matériau à base de fer et de nickel, déposé sur une couche isolante recouvrant la couche magnétique, ou bien obtenus en implantant des ions dans la partie supérieure de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contigus ; du fait de leur forme, deux motifs adjacents délimitent entre eux deux cavités ou creux.

Le déplacement des bulles le long de ces motifs se fait généralement pendant une durée égale au tiers de la période de rotation du champ magnétique $H_T$ plan, les bulles restant immobiles dans les cavités définies entre deux motifs adjacents, pendant le reste du cycle. Ces cavités constituent des positions dites stables. On réalise ainsi des registres à décalage dans lesquels l'information binaire "1" est représentée par la présence d'une bulle et l'information binaire "0" par l'absence d'une bulle.

En plus de ces motifs de propagation, il est nécessaire d'utiliser des conducteurs électriques pour réaliser dans la mémoire à bulles, des fonctions d'écriture, d'enregistrement de l'information, de lecture non destructive, de transfert de registre à registre et d'effacement.

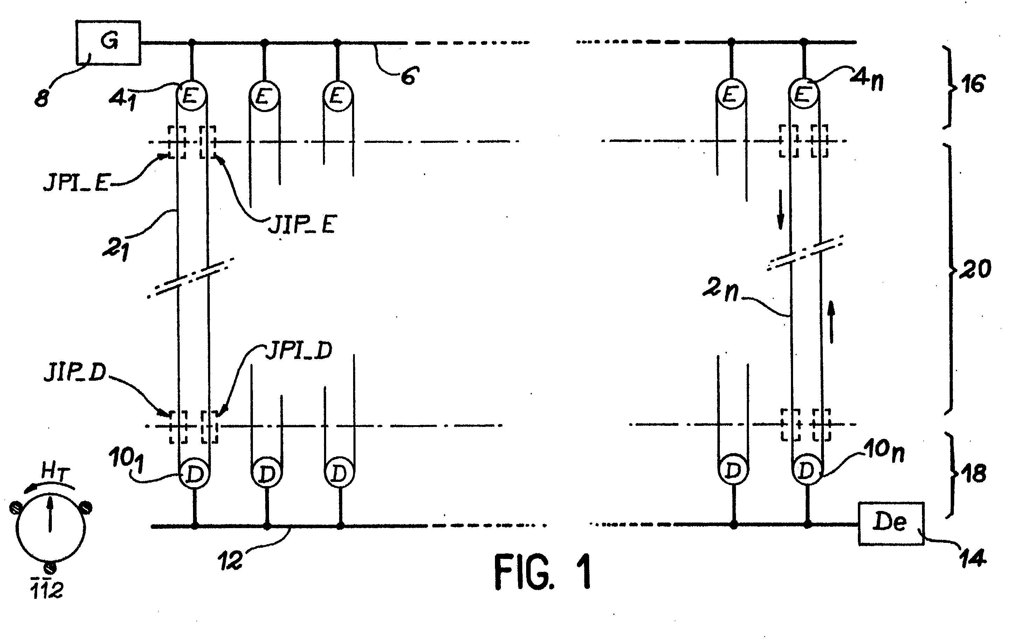

On a représenté schématiquement sur la figure 1 la structure connue d'une mémoire à bulles magnétiques. Elle comprend un ensemble de boucles, dites boucles mineures, servant au stockage des informations, parallèles entre elles et disposées suivant un axe de facile aimantation $\overline{112}$ du matériau magnétique. Chaque boucle mineure est reliée par une porte d'échange $4_1$, ..., $4_n$ à une boucle majeure d'écriture 6 comportant à une extrémité un générateur de bulle magnétique 8. La boucle majeure d'écriture 6 est alignée suivant un axe perpendiculaire à l'axe des boucles mineures ; chaque porte d'échange permet l'inscription d'informations dans une boucle mineure.

Chaque boucle mineure est également reliée par une porte de duplication $10_1$, ..., $10_n$ à une boucle majeure de lecture 12, parallèle à la boucle majeure d'écriture 6. La boucle majeure de lecture 12 se termine par un détecteur 14 constituant un moyen de lecture.

Une mémoire à bulles magnétiques en technologie hybride comporte deux régions 16, 18 comprenant des motifs déposés, et une région 20 comprenant des motifs non implantés. Tous les éléments de la mémoire à bulles sont contenus uniquement dans les régions 16 et 18, à l'exception des boucles mineures qui s'étendent chacune sur les trois régions. Chaque boucle mineure comporte donc quatre jonctions, JPI-E, JIP-E, JIP-D et JPI-D, qui constituent des jonctions entre des chemins de propagation situés dans des régions différentes.

L'invention concerne les jonctions permettant à une bulle magnétique de passer d'un chemin de propagation défini par des motifs déposés vers un chemin de propagation défini par des motifs non implantés, c'est-à-dire les jonctions notées JPI-E et JPI-D sur la figure 1.

De telles jonctions sont décrites notamment dans la demande de brevet EP-A2-0 081 215 déposée le 3 décembre 1982 au nom de HITACHI. On a représenté respectivement sur les figures 2 et 3 des jonctions PI-E et PI-D suivant l'enseignement de ce document.

Sur chaque figure, un premier chemin de propagation est défini par une suite de motifs déposés 22, 24 et 26, et un second chemin de propagation est défini par une frontière 28 entre une zone implantée 30 et une zone non implantée 32. Les deux chemins de propagation ont des directions générales parallèles et se recouvrent au niveau du motif déposé 26.

La jonction est définie par la zone de recouvrement 34 entre les deux chemins de propagation. Elle a une longueur importante devant le diamètre d'une bulle magnétique. Cette longueur est sensiblement égale à la longueur du motif déposé 26.

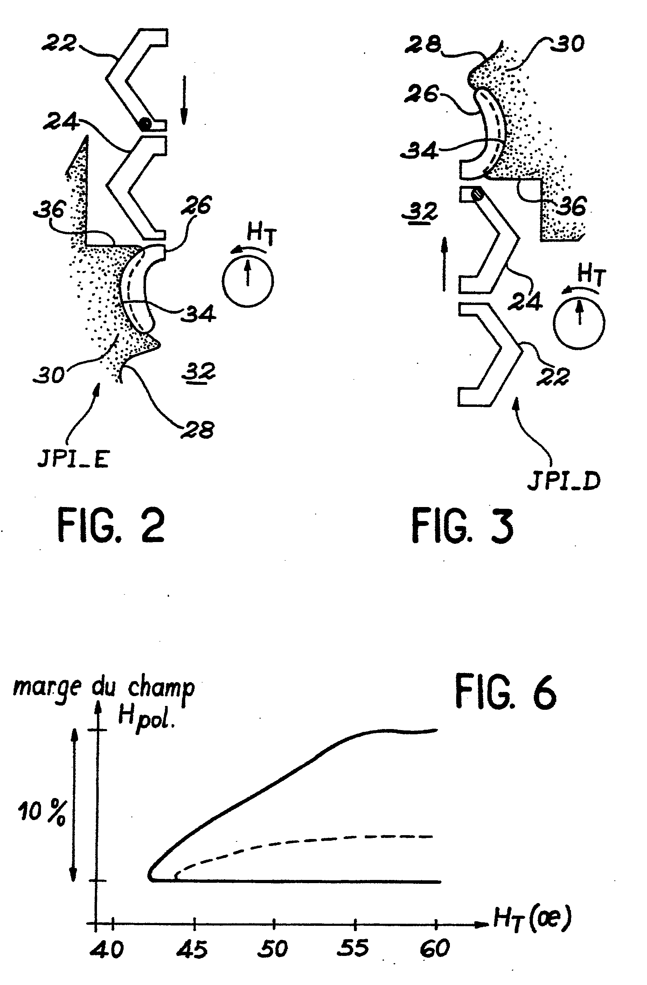

D'autre part, les jonctions représentées sur les figures 2 et 3 sont également caractérisées par une forme particulière du motif déposé 26, qui est courbé de manière à suivre la frontière entre la zone implantée et la zone non implantée, et par une direction particulière de la partie 36 de la frontière 28, qui se trouve juste avant le début du second chemin de propagation. Cette partie 36 a une direction perpendiculaire à l'axe des premier et second chemins de propagation.

Une première variante à la jonction représentée sur les figures 2 et 3 est décrite dans le brevet US-A-4 525 808 délivré le 25 juin 1985 au nom de HITACHI. L'objet de ce brevet est de modifier la direction de la partie 36 de la frontière entre zones implantée et non implantée, de manière à obtenir une meilleure marge sur le champ $H_{pol}$ pour le passage d'une bulle magnétique du premier chemin de propagation vers le second chemin de propagation.

Une autre variante est également décrite dans l'article "Characteristics of junctions between ion-implanted and permalloy tracks in hybrid bubble devices" de N. Kodama et al. paru en sept. 84 dans IEEE Transactions on Magnetics Vol.MAG20, n°5, dans lequel il est proposé d'orienter la partie 36 de la frontière suivant un axe de facile aimantation du matériau magnétique et d'utiliser un motif déposé 26 à volume important.

Une autre amélioration de la jonction PI est décrite dans l'article "Design of 2 µm-period minor loops in hybrid bubble memory devices" de M. Ohashi et al. paru en sept.84 dans IEEE Transactions on Magnetics Vol.MAG20, n°5, dans lequel on préconise une jonction dont la direction est perpendiculaire à l'axe d'alignement des chemins de propagation.

Il apparaît donc que, selon l'art connu, une jonction permettant de transférer une bulle magnétique d'un chemin de propagation défini par des motifs déposés vers un chemin de propagation défini par la frontière entre une zone implantée et une zone non implantée, est réalisée par le recouvrement entre un motif déposé et ladite frontière sur une longueur importante qui est de l'ordre de grandeur d'un motif déposé. On constate de plus que l'orientation de la jonction, par rapport aux axes de facile aimantation du matériau magnétique, est telle que la zone de recouvrement des deux chemins de propagation ne constitue pas une position stable pour une bulle magnétique.

Il faut noter que, d'un point de vue technologique, ce recouvrement des chemins de propagation sur une longueur importante pose des problèmes d'alignement entre les niveaux technologiques. En effet, un léger décalage en translation ou en rotation entre les masques utilisés pour l'implantation ionique et pour la gravure des motifs déposés déforme la zone de recouvrement (largeur non constante par exemple) ce qui peut être néfaste pour la marge de champ $H_{pol}$ au moment du passage de la bulle magnétique du premier chemin de propagation vers le second chemin de propagation.

L'invention a notamment pour but d'éviter ces problèmes dus à un défaut d'alignement des niveaux technologiques.

L'invention a également pour but de procurer une marge de champ $H_{pol}$ importante pour le franchissement d'une bulle magnétique du premier chemin de propagation vers le second chemin de propagation.

Ces buts sont atteints par une jonction réalisée par un recouvrement entre un motif déposé et la zone implantée dont la surface est de l'ordre de grandeur de la surface d'une bulle magnétique. Pour que le transfert de la bulle magnétique se fasse correctement, il est ici nécessaire que la zone de recouvrement constitue une position stable pour la bulle magnétique. La structure de la jonction proposée par l'invention est donc totalement différente des structures des jonctions connues.

De manière précise, l'invention telle que revendiquée dans la revendication 1 comporte une mémoire à bulles magnétiques en technologie hybride comprenant une suite de motifs déposés, alignés suivant un axe de facile aimantation d'un matériau magnétique de la mémoire et définissant un premier chemin de propagation pour des bulles magnétiques, et une suite de motifs non implantés, alignés suivant le même axe et définissant un second chemin de propagation le long de la frontière entre la zone implantée et la zone non implantée, une jonction étant réalisée entre lesdits chemins de propagation pour permettre le passage d'une bulle magnétique du premier chemin vers le second chemin, ladite jonction étant définie par un recouvrement entre lesdits chemins de propagation et étant caractérisée en ce que le recouvrement a une surface de l'ordre de grandeur de la taille d'une bulle magnétique, et en ce que la zone de recouvrement constitue, pour chacun des chemins de propagation, une position stable pour une bulle magnétique.

De manière préférée, les frontières entre la zone implantée et la zone non implantée de chaque côté de la zone de recouvrement sont chacune parallèles à un axe de facile aimantation du matériau magnétique de la mémoire.

De manière avantageuse, la distance entre la zone de recouvrement et la première position stable sur le second chemin de propagation est au moins égale à la moitié du pas des motifs non implantés.

De manière préférée, le dernier motif déposé du premier chemin de propagation a un volume important et se termine en pointe au niveau de la jonction dans la partie descendante du motif.

Les caractéristiques et avantages de l'invention ressortiront mieux de la description qui va suivre, donnée à titre illustratif mais non limitatif, en référence aux dessins annexés, sur lesquels :

- la figure 1, déjà décrite, illustre schématiquement la structure classique d'une mémoire à bulles en technologie hybride,
- la figure 2, déjà décrite, représente schématiquement une jonction PI-E au niveau d'une porte d'échange selon l'art antérieur,
- la figure 3, déjà décrite, représente schématiquement une jonction PI-D au niveau d'une porte de duplication selon l'art antérieur,
- la figure 4 représente schématiquement une jonction PI-E selon l'invention,
- la figure 5 représente schématiquement une jonction PI-D selon l'invention, et
- la figure 6 est un diagramme montrant la marge de phase sur le champ de polarisation $H_{pol}$ pour le transfert d'une bulle magnétique du premier chemin de propagation vers le second chemin de propagation pour une jonction connue et pour une jonction conforme à l'invention.

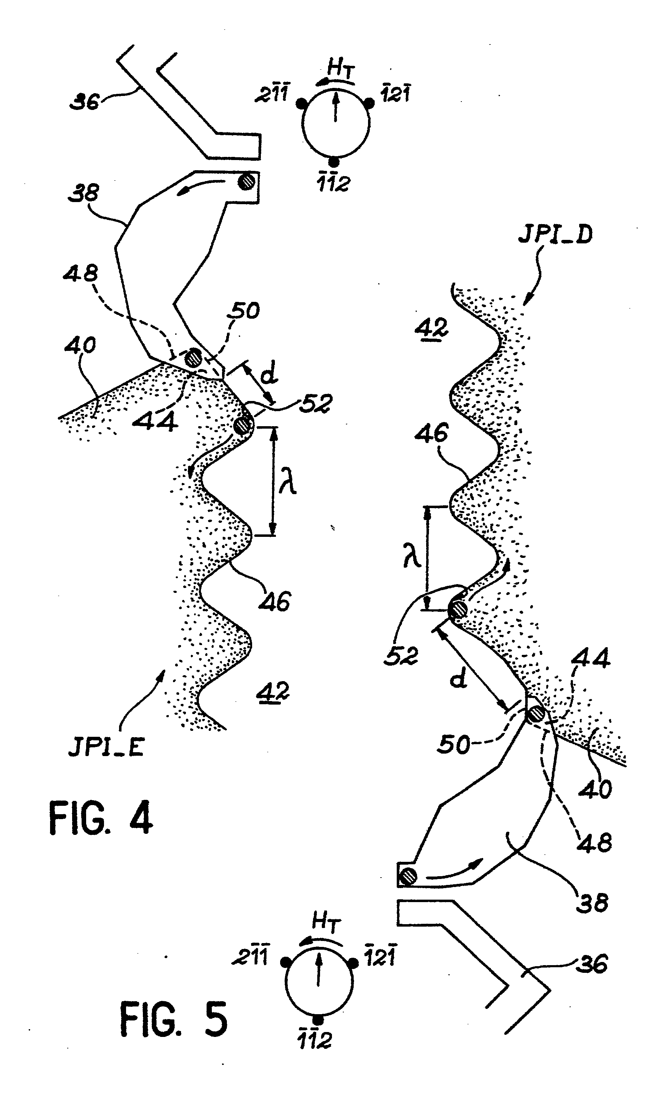

On va tout d'abord décrire, en référence à la figure 4, une jonction PI-E selon l'invention. Sur la figure 4, on a représenté un motif déposé 36 et un motif déposé 38 constituant l'avant-dernier et le dernier éléments d'une suite de motifs déposés définissant un premier chemin de propagation d'une bulle magnétique. On a également représenté une zone implantée 40 dont le pourtour, formant une frontière 46 entre cette zone implantée 40 et une zone non-implantée 42, définit un second chemin de propagation pour une bulle magnétique. Les deux chemins de propagation ont une direction générale identique, parallèle à un axe de facile aimantation 112 du matériau magnétique de la mémoire.

La jonction proprement dite est formée par le recouvrement 44 entre une extrémité du dernier motif déposé 38 et la zone implantée 40. Conformément à l'invention, la surface de recouvrement est sensiblement égale à la taille d'une bulle magnétique, et cette position de recouvrement est une position stable pour chacun des deux chemins de propagation.

Pour que le transfert d'une bulle magnétique du premier chemin de propagation vers le second chemin de propagation se fasse correctement, il faut d'abord que la bulle franchisse la frontière entre zone non implantée et zone implantée. Ce franchissement est facilité, de manière connue par un motif déposé 38 à volume important.

Il faut ensuite que la bulle magnétique soit fortement attirée sur le second chemin de propagation pour s'échapper du motif déposé. Ceci est obtenu selon un mode de réalisation préféré de l'invention en affaiblissant dans sa partie descendante le motif déposé 38 par une forme en pointe au niveau de la zone de recouvrement 44.

La stabilité de la bulle sur le second chemin de propagation, dans la position de recouvrement, est réalisée de manière très efficace, comme représenté sur la figure 4, par un creux implanté dont les bords 48, 50 sont parallèles à deux axes de facile aimantation $2\overline{1}\overline{1}$ et $\overline{1}2\overline{1}$ du matériau magnétique de la mémoire.

La stabilité du premier creux implanté 52 après la position de recouvrement sur le second chemin de propagation peut être affaiblie par la pointe du motif déposé 38. L'influence de cette pointe peut même conduire, dans certains cas, à la disparition de la bulle magnétique entre la jonction 44 et le creux 52. Pour éviter celà, il convient que la distance d entre l'extrémité de la pointe du motif déposé 38 et la première position stable sur le second chemin de propagation soit assez importante. Selon l'invention, cette distance est au moins égale à $\dfrac{\lambda}{2}$, où $\lambda$ est le pas des motifs non-implantés définissant le second chemin de propagation.

Dans la figure 4, on a représenté une jonction PI-E conforme à l'invention permettant à une bulle magnétique de passer d'un chemin de propagation défini par des motifs déposés à un chemin de propagation défini par la frontière entre une zone implantée et une zone non-implantée. Cette jonction se situe sur une boucle mineure à proximité d'une porte d'échange E de la mémoire à bulles magnétiques (voir figure 1). Une jonction de même nature est réalisée sur la boucle mineure à proximité de la porte de duplication. Cette jonction, notée PI-D sur la figure 1, est représentée en détail sur la figure 5.

Sur cette figure, les éléments identiques à ceux de la figure 4 portent les mêmes références. Le premier chemin de propagation est défini par des motifs déposés dont l'avant-dernier motif déposé 36 et le dernier motif déposé 38 sont représentés sur la figure. Le deuxième chemin de propagation est défini par la frontière 46 entre une zone implantée 40 et une zone non-implantée 42. Les deux chemins de propagation ont une direction générale identique; celle-ci est parallèle à l'axe de facile aimantation $\overline{1}\overline{1}2$ du matérieur magnétique de la mémoire.

Conformément à l'invention, le recouvrement entre les deux chemins de propagation se fait sur une surface 44 sensiblement égale à la surface d'une bulle magnétique, et cette position de recouvrement est une position stable sur chacun des deux chemins de propagation.

Comme dans la figure 4, le dernier motif déposé 38 du premier chemin de propagation a un volume important, pour favoriser le franchissement par la bulle magnétique de la frontière entre la zone non-implantée et la zone implantée et ce motif se termine en pointe, sur la partie descendante du motif, pour affaiblir l'influence du motif déposé et faciliter ainsi le transfert de la bulle magnétique de la position de recouvrement vers le second chemin de propagation.

Comme dans la jonction représentée sur la figure 4, la stabilité du second chemin de propagation au niveau de la zone de recouvrement 44, est obtenue par un creux non implanté dont les bords 48, 50 sont parallèles à des axes de facile aimantation $\overline{1}\overline{1}2$ et $2\overline{1}\overline{1}$ du matériau magnétique de la mémoire.

Enfin, la pointe du motif déposé 38 peut, comme dans la jonction représentée sur la figure 4, être susceptible d'affaiblir la stabilité du premier creux implanté 52 sur le second chemin de propagation, après la zone de recouvrement 44. Ce problème peut être évité en fixant une distance d, entre la zone de recouvrement 44 et le premier creux 52 sur le second chemin de propagation, égale au moins à $\dfrac{\lambda}{2}$, où $\lambda$ est le pas des motifs non-implantés définissant le second chemin de propagation.

Les jonctions de type PI selon l'invention, et dont des modes particuliers de réalisation ont été donnés en référence aux figures 4 et 5, comportent une surface de recouvrement entre les deux chemins de propagation qui est de l'ordre de grandeur d'une bulle magnétique. Ceci est très intéressant du point de vue technologique car les tolérances d'alignement entre les différents niveaux technologiques sont plus importantes que dans les jonctions selon l'art intérieur où le recouvrement est réalisé sur une distance importante.

En effet, si avec un alignement correct la zone de recouvrement a un diamètre de l'ordre de 1 µm (taille d'une bulle magnétique), cette zone de recouvrement, même en cas de mauvais alignement entre les niveaux technologiques, reste en général comprise entre 0,5 et 1,5 µm, ce qui reste tolérable et n'affecte pas sensiblement la marge du champ $H_{pol}$ pour le franchissement de la bulle magnétique.

De plus, le fait que la position de recouvrement coïncide, avec pour chacun des deux chemins de propagation, avec une position stable, confère une marge de champ $H_{pol}$ importante aux jonctions de type PI selon l'invention.

Le diagramme de la figure 6 illustre cette marge de phase pour une jonction conforme à l'invention (trait plein) et pour une jonction classique (trait tireté). Il apparaît que la marge du champ $H_{pol}$ n'excède pas 3% pour une jonction classique, quelle que soit l'intensité du champ tournant $H_T$ alors que cette marge de phase est de l'ordre de 5% pour un champ de 50 oersted pour une jonction selon l'invention et atteint environ 10% pour un champ supérieur à 55 oersted.

## Revendications

1. Mémoire à bulles magnétiques en technologie hybride comprenant une suite de motifs déposés (36, 38), alignés suivant un axe de facile aimantation ( $\overline{11}2$, $11\overline{2}$ ) d'un matériau magnétique de la mémoire et définissant un premier chemin de propagation pour des bulles magnétiques, et une suite de motifs non-implantés, alignés suivant le même axe et définissant un second chemin de propagation le long de la frontière (46) entre une zone implantée (40) et une zone non implantée (42), une jonction étant réalisée entre lesdits chemins de propagation pour permettre le passage d'une bulle magnétique du premier chemin vers le second chemin, ladite jonction étant définie par un recouvrement entre lesdits chemins de propagation et étant caractérisée en ce que la zone de recouvrement (44) a une surface de l'ordre de grandeur de la taille d'une bulle magnétique, et en ce que la zone de recouvrement constitue pour chacun des chemins de propagation, une position stable pour une bulle magnétique.

2. Mémoire selon la revendication 1, caractérisée en ce que, au niveau de la zone de recouvrement (44), le second chemin de propagation présente un creux implanté dont les bords (48, 50) sont chacun parallèles à un axe de facile aimantation du matériau magnétique de la mémoire.

3. Mémoire selon l'une quelconque des revendications 1 et 2, caractérisée en ce que la distance (d) entre la zone de recouvrement (44) et la première position stable (52) sur le second chemin de propagation, après ladite zone de recouvrement, est au moins égale à la moitié du pas (λ) des motifs non-implantés des motifs définissant ledit second chemin de propagation.

4. Mémoire selon l'une quelconque des revendications 1 à 3, caractérisée en ce que le dernier motif déposé (38) du premier chemin de propagation a un volume important et se termine en pointe, au niveau de la zone de recouvrement (44) dans sa partie descendante.

## Patentansprüche

1. Magnetblasenspeicher in Hybridtechnologie mit einer Reihe von abgeschiedenen Einheiten (36, 38), die entlang einer Achse leichter Magnetisierbarkeit ( $\overline{11}2$, $11\overline{2}$ ) eines ersten magnetischen Materials des Speichers aufgereiht sind und einen ersten Fortbewegungspfad für Magnetblasen bilden, und mit einer Reihe nichtimplantierter Einheiten, die entlang derselben Achse aufgereiht sind und einen zweiten Fortbewegungspfad entlang der Grenze (46) zwischen einer implantierten (40) und einer nicht-implantierten (42) Zone bilden, wobei eine Verbindung zwischen den Fortbewegungspfaden gebildet ist, um den Übergang einer Magnetblase vom ersten Pfad zum zweiten Pfad zu ermöglichen, wobei diese Verbindung von einer Überdeckung zwischen den Fortbewegungspfaden gebildet wird und dadurch gekennzeichnet ist, daß die Überdeckungszone (44) eine Oberfläche in der Größenordnung einer Magnetblase hat und daß die Überdeckungszone für jeden der Fortbewegungspfade eine stabile Position für eine Magnetblase darstellt.

2. Magnetblasenspeicher nach Anspruch 1, dadurch gekennzeichnet, daß der zweite Fortbewegungspfad auf der Höhe der Überdeckungszone (44) einen implantierten Hohlraum besitzt, dessen Ränder (48, 50) jeweils parallel einer Achse leichter Magnetisierbarkeit des magnetischen Materials des Speichers ist.

3. Magnetblasenspeicher nach einem der Ansprüche 1 und 2, dadurch gekennzeichnet, daß der Abstand (d) zwischen der Überdeckungszone (44) und der ersten stabilen Position (52) auf dem zweiten Fortbewegungspfad nach der Überdeckungszone wenigstens gleich der Hälfte der Länge (λ) der nichtimplantierten Einheiten ist, die den zweiten Fortbewegungspfad bilden.

4. Magnetblasenspeicher nach einem der Ansprüche 1 bis 3, dadurch gekennzeichnet, daß die letzte abgeschiedene Einheit (38) des ersten Fortbewegungspfads ein großes Volumen hat und auf der Höhe der Überdeckungszone (44) in ihrem absteigenden Teil in einer Spitze ausläuft.

## Claims

1. Magnetic bubble memory in hybrid technology, comprising a sequence of deposited patterns (36, 38) aligned along an easy magnetization axis ( $\overline{11}2$, $11\overline{2}$ ) of a magnetic material of the memory and forming a first propagation track for magnetic bubbles, and a sequence of non-implanted patterns aligned along the same axis and defining a second propagation track along the boundary (46) between an implanted zone (40) and a non-implanted zone (42), a junction being made between such propagation tracks to enable a magnetic bubble to pass from the first track to the second track, such junction being defined by an overlap between such propagation tracks, characterized in that the overlap zone (44) has a surface of the order of magnitude of the size of a magnetic bubble and forms for each of the propagation tracks a stable position for a magnetic bubble.

2. Memory according to claim 1, characterized in that at the overlap zone (44) the second propagation track has an implanted hollow whose edges (48, 50) are each parallel with an easy magnetization axis of the magnetic material of the memory.

3. Memory according to either of the claims 1 and 2, characterized in that the distance (d) between the overlap zone (44) and the first stable position (52) on the second propagation track following such overlap zone is at least equal to half the size ($\lambda$) of each of the non-implanted patterns of the patterns defining such second propagation track.

4. Memory according to any one of the claims 1 to 3, characterized in that the last deposited pattern (38) of the first propagation track has a considerable volume and terminates in a point at the overlap zone (44) in its descending portion.

FIG. 1

FIG. 2

FIG. 3

FIG. 6

EP 0 238 370 B1

FIG. 4

FIG. 5